(19) Europäisches Patentamt
European Patent Office
Office européen des brevets

(11) Publication number: **0 104 412 B1**

(12) **EUROPEAN PATENT SPECIFICATION**

(45) Date of publication of patent specification: **07.01.88**

(51) Int. Cl.⁴: **H 01 L 21/225,** C 08 L 75/04, C 08 G 79/08, C 30 B 31/02

(21) Application number: **83108196.3**

(22) Date of filing: **19.08.83**

(54) **Polymeric boron-nitrogen dopant.**

(30) Priority: **23.09.82 US 421945**

(43) Date of publication of application:
**04.04.84 Bulletin 84/14**

(45) Publication of the grant of the patent:
**07.01.88 Bulletin 88/01**

(84) Designated Contracting States:
**BE DE FR GB IT NL**

(56) References cited:
**AT-B- 338 335**
**DE-A-2 614 324**
**GB-A-1 012 317**
**GB-A-1 018 031**
**GB-A-1 485 484**
**US-A-3 166 520**
**US-A-3 341 474**
**US-A-3 375 274**

**JOURNAL OF THE CHEMICAL SOCIETY, 1959, part III, London, AUBREY, LAPPERT "Cyclic Organic Boron Compounds", pages 2927-2931**

(73) Proprietor: **ALLIED CORPORATION**
**Columbia Road and Park Avenue**
**P.O. Box 2245R (Law Dept.)**
**Morristown New Jersey 07960 (US)**

(72) Inventor: **Kirtley, Stephen Wakefield**
**129 Northington Drive**
**East Amherst New York 14051 (US)**
Inventor: **Wooster, George Sidney**
**35 Pleasant Avenue**
**Hamburg New York 15075 (US)**

(74) Representative: **Baillie, Iain Cameron et al**
**c/o Ladas & Parry Isartorplatz 5**
**D-8000 München 2 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 104 412 B1

**Description**

Technical Field

This invention relates to the use of boron-nitrogen polymers as dopant materials used in semiconductor manufacture and more particularly to dopant compositions adapted to be spun on to a semiconductor substrate and used in integrated circuit manufacture. The dopant comprises a polymer, at least a substantial part of the backbone of which contains boron-nitrogen borazole (borazine) monomer units, in the form of a glassy resin dissolved in an organic solvent.

BACKGROUND OF THE INVENTION

Since the diffusion of boron impurity atoms into silica is necessary for semiconductor device fabrication, a number of boron containing chemicals and processes to "dope" the boron into the silicon have been proposed. Some of the known prior art products (and processes) are the following:

1) boron nitride wafers are oxidized in a diffusion furnace to $B_2O_3$ or $HBO_2$, and the oxide is transferred in the vapor phase to the silicon wafer surface or boric oxide wafers can be used directly;

2) boron tribromide liquid is vaporized and oxidized in the direction furnace to $B_2O_3$ which coats the wafers from the vapor phase;

3) boron trichloride is used as a source of boron ions for use with an ion implanter.

Less commonly used sources of boron include the boron spin-on solutions, (which typically are $B_2O_3$ or a borosilicate glass precursor dissolved in a solvent) borosilicate films deposited by chemical vapor deposition, or diborane ($B_2H_6$) gas, which is used in a procedure similar to that used for $BBr_3$.

While the above are effective boron sources, all have disadvantages. Specifically, ion implantation involves high capital costs, low throughput, and damage to the silicon crystal structure, while boron oxide and related sources are unusually sensitive to moisture, create damaged or stained silicon surfaces, and/or involve costly and complicated processes to achieve quality doping.

Advantageously, the polymer to be useful must be homogeneous and soluble so that it is easily distributed uniformly on the surface, such as by the spin-on method; it must be relatively non volatile so that when the solvent is removed and the material heated to diffusion temperatures the desired film will be substantialy intact; it must be capable of being rendered insoluble i.e., cross linked thermally or otherwise; and it must be characterized as glassy rather than crystalline.

It is thus apparent that a need exists for a more economical and efficiently applied spin-on boron dopant system.

SUMMARY OF THE INVENTION

It is an object of the invention to provide a polymeric borazole spin-on boron dopant that offers potentially significant advantages over the prior art. More particularly, it is an object of the invention to provide a boron-nitrogen species for semiconductor dopant compositions that, as a diffusion source, is less sensitive to moisture and thereby affords greater processing latitude, and is less prone to create damage to and/or staining of the silicon crystal substrate.

The polymeric borazoles employed in the invention are polymers derived from the class of materials known as borazines (or borazoles). These borazines are heterocyclic hexatomic ring compounds having the general formula $(XBNY)_3$ with the substituents X and Y on the ring designated with "B" and "N" prefixes, respectively, to indicate the positions.

The polymers derived from the borazines are of two general types:

1) polymers with borazine rings linked directly between a boron in one ring and a nitrogen atom in the adjacent ring.

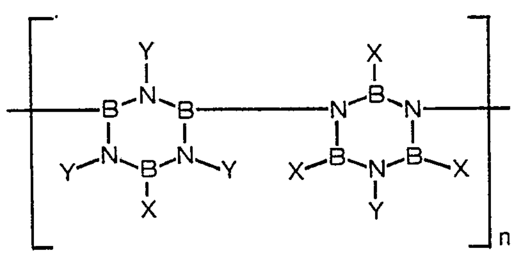

and

2) polymers, at least a substantial portion of whose backbone is borazine rings linked via other (different) groups Z, i.e.:

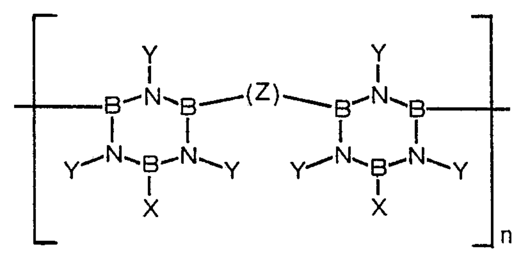

wherein Z is selected from the group consisting of —N(R)—, —O—, —N(R)—R'—N(R)—, and —R—, and wherein R and R' denote organic radicals of 1 to 10 carbon atoms and X and Y are radicals selected from the group consisting of hydrogen, alkyl radicals of 1—8 carbon atoms, unsubstituted aromatic alkyl-, halogen-, hydroxy, and amino-substituted aromatic radicals, heterocyclic aromatic, 1—6 carbon atom alkyl substituted heterocyclic aromatic, amino, hydroxy, alkoxy and halogen radicals.

These borazine polymers can be produced as homopolymers from a single monomeric borazine or as copolymeres from two different borazines.

## DESCRIPTION OF THE PREFERRED EMBODIMENTS

In preparing the polymeric dopant composition in accordance with the invention, a polymeric borazole is produced by first reacting $BCl_3$ and an amine at temperatures between −60°C and −5°C in an inert solvent to form an intermediate triaminoborane. After removal of the amine hydrochloride salt, the intermediate is polymerized via thermal condensation at a temperature between 380—420°C. The polymer, in the form of a glassy resin, is then dissolved in an organic solvent such as toluene or xylene at a 1 to 20% (wt/wt) level and spun-on silicon wafers to function as a boron impurity source (dopant) in thermal diffusions. The doped wafers thus prepared are then used in integrated circuit manufacture.

In accordance with the invention, the polymers derived from the borazines are of two general types:

1) polymers with borazine rings linked directly between a boron in one of the six-membered boron/nitrogen ring and a nitrogen atom in the adjacent six-membered boron/nitrogen ring.

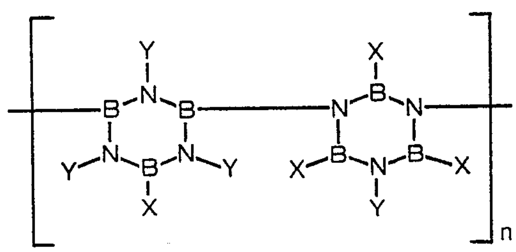

and

2) polymers, at least a substantial portion of whose backbone is borazine rings linked via other (different) groups Z, i.e.:

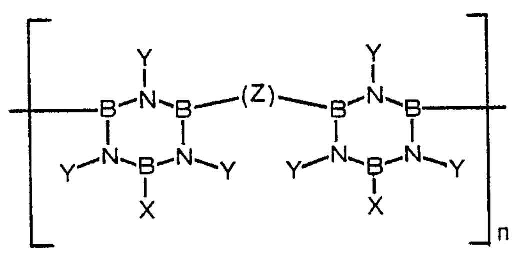

wherein Z is selected from the group consisting of —N(R)—, —O—, —N(R)—R'—N(R)—, and —R—, and wherein R and R' denote organic radicals of 1 to 10 carbon atoms and X and Y are radicals selected from the group consisting of hydrogen, alkyl radicals of 1—8 carbon atoms, unsubstituted aromatic alkyl-, halogen-, hydroxy, and amino-substituted aromatic radicals, heterocyclic aromatic, 1—6 carbon atom alkyl substituted heterocyclic aromatic, amino, hydroxy, alkoxy and halogen radicals.

These borazine polymers can be produced as homopolymers from a single monomeric borazine or as copolymeres from two different borazines utilizing a variety of synthetic routes known to those skilled in the art of which the English, et al. U.S. Pat. 3,166,520 and Aubrey, et al., JCS (1959) pp. 2927—31 are illustrative references. Thus, homopolymers can be produced from the thermal polymerization of B-amino borazines (two or three —NHR— or —$NR_2$ groups) or thermal polymerization of borazines with X and Y being selected from the group above defined. Similarly, copolymers can be made by reacting two different borazines wherein X and Y are chosen as above defined. Copolymers can also be produced by reacting B-amino or B-halogen borazines with a wide variety of aliphatic, aromatic, and heterocyclic diamines. A borozine copolymer can be produced from the reaction of a cyclic methyl-amino-borane trimer with a diene or polyene. B-halogen borazines can be copolymerized with N-lithiated borazines, and borazine copolymers with rings linked via oxygen can be made by the controlled hydrolysis of B-halogen borazines. It will be apparent that the foregoing are not all inclusive and that other borazine polymers within the above definition are intended.

In employing the borazine polymers of the invention, the traditional advantages of a spin-on dopant are maintained i.e., greater uniformity, less capital cost, higher throughput, more control, and less cleaning of diffusion tubes and boats.

The invention will be further described by the following specific examples, the details of which, it will be understood, are given primarily for purpose of illustration and not for the limitation of the invention in its broader aspect.

Example 1

In accordance with the invention and as shown by the reaction below, boron trichloride ($BCl_3$) (35 g, 0.3 moles) gas is added to a −5°C to −60°C solution of cyclohexyl amine (195 g, 2.0 moles) dissolved in 2 liters of petroleum ether (bp 30—60°C). The reaction results in the formation of a triaminoborane, $B(NHCy)_3$ (where Cy = $C_6H_{11}$, cyclohexyl), and the cyclohexylamine hydrochloride salt. After the salt is removed by filtration, the triaminoborane is heated under a nitrogen atmosphere to 300°C for 1—2 hours to form a monomeric intermediate and thereafter heated to 380—420°C over a 2—4 hour period, during which time a condensation polymerization occurs and cyclohexylamine is evolved. A glassy resin (string temperature 140 ± 30°C) is formed upon cooling; this amber solid is dissolved in toluene (xylene may also be used) at the 1 to 20% (wt/wt) level. The resulting product is a dark amber to almost black solution.

(a) $BCl_3 + 6NH_2Cy \longrightarrow B(NHCy)_3 + 3NH_3Cy^+Cl^-$

(b) $3B(NHCy)_3$

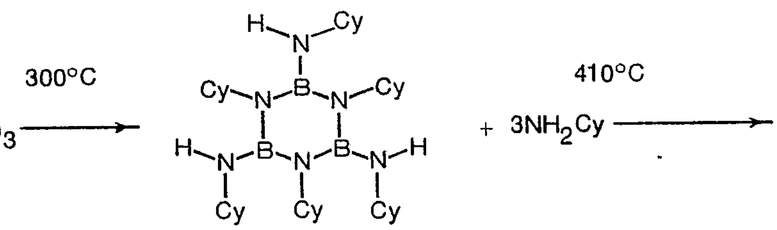


+ $3NH_2Cy$

[intermediate]

$[B_3(NCy)_4NHCy]_x + xNH_2Cy$

[condensation polymer]

Example 2

The procedure of Example 1 is repeated except that 186 g (2.0 moles) of aniline is used in place of cyclohexylamine. The aniline reacts to form the triaminoborane $B(NHPh)_3$, (Ph = $-C_6H_5$) which is polymerized under the same conditions as in Example 1 to yield $[B_3L(NPh)_4(NHPh)]_x$.

Example 3

The procedure of Example 1 is repeated except that 90 g (2.0 moles) of ethylamine is used in place of cyclohexylamine. The ethylamine reacts to form $B(NHEt)_3$ which is polymerized at a temperature between 320°C and 360°C to produce $[B_3(NEt)_4(NHEt)]_x$ wherein Et = $-C_2H_5$.

Example 4

In applying the polymeric composition to substrates, 2—6 ml of the solutions, prepared in accordance to Example 1 (and Examples 2 and 3), are spun-on by dispensing the polymeric solution onto the surface of a silicon wafer and the wafer rotated at 2,000—10,000 rpm, which results in thin films (100—7000A) of the polymer. The treated wafers, which may be held for up to 24 hours, are placed in a diffusion furnace and the wafer diffused according to one of the following diffusion procedures.

*Film Diffusion*

It will be understood by those skilled in the art that diffusion times, temperatures, furnace ambients, and exact processes may vary. Described below are: two typical bipolar base diffusion processes (a) and (c); a bipolar isolation diffusion (b); and a metal oxide silicon (MOS) source/drain diffusion (d).

(a) A conventional two-step diffusion process involves a predeposition step under nitrogen at temperatures between 850°C and 1000°C for diffusion times up to 1 hour to achieve sheet resistivities from 15—275 ohms per square. This predeposition step is followed by a deglazing step in concentrated aqueous HF, and a drive step at 1050°C—1150°C for 1—2 hours under an atmosphere selected from oxygen, wet oxygen and nitrogen and mixtures thereof.

(b) A less conventional one-step diffusion process involves a predeposition stage that begins under a nitrogen atmosphere at 850°C—1000°C for 5—60 minutes and is immediately followed by a wet oxygen stage at a slightly lower temperature for 5—45 minutes. The final stage of this one step (single diffusion tube) process involves raising the temperature to 1050°C—1150°C and diffusing the film for 1—2 hours under an atmosphere of oxygen, wet oxygen and nitrogen ambients and mixtures thereof. This one step

process eliminates the HF deglazing step as well as the utilization of two (or more) diffusion tubes that would be required in procedure (a).

(c) A bipolar isolation diffusion is effected as in procedure (a), but higher predeposition temperatures (1100°C—1200°C) are employed to yield sheet resistivities of 1—4 ohms per square.

(d) A complementary CMOS or positive MOS (PMOS) source/drain diffusion can also be carried out as in procedure (a) with the drive step omitted. In a typical run, at a temperature of 935°C for 1 hour under a $N_2$ atmosphere, sheet resistivities of 40 ohms per square at a junction depth of 0.4 microns can be achieved.

*Industrial Applicability*

The boron-nitrogen product used in accordance with the invention provides an effective boron source film for both base and isolation diffusion applications for bipolar integrated circuits and evaluated for absolute sheet resistivities. The resulting products are characterized as having single crystal across-the-wafer and wafer-to-wafer resitivity uniformity as well as batch-to-batch resistivitiy uniformity, minimal wafer damage and staining, ease of processing, and compatibility with existing processes. In each of these areas the polymeric source film forming compositions used in accordance with the invention performs effectively.

This product may be used on a wide range of devices for the semiconductor fabrication industry, e.g., bipolar and MOS integrated circuits, discrete devices, photovoltaic (solar) cells, and the like. Of particular applicability is usage, of the borazine ring containing polymer composition of the invention, by manufacturers of bipolar integrated circuits for base and isolation diffusions in a manner typically described by Example 4.

**Claims**

1. The use of a conductivity inducing glassy polymeric, spun-on film forming composition for the boron/nitrogen doping of semi-conductors, said composition containing at least 1.0 percent by weight in a volatile solvent of a polymer at least a substantial part of the back-bone of which is selected from:

(a) polymers with borazine rings linked directly between a boron in one ring and a nitrogen atom in the adjacent ring

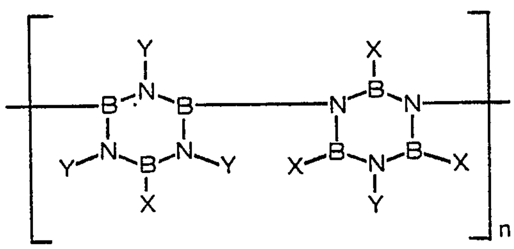

and

(b) polymers with borazine rings linked via groups Z.

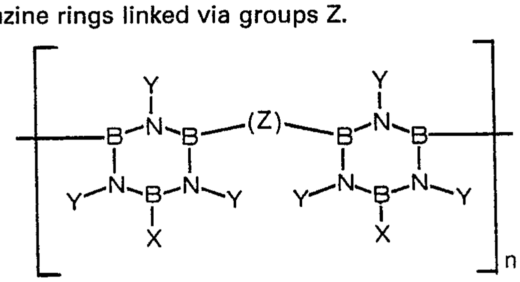

wherein X and Y locate the substituents on the ring boron and nitrogen atoms and Z is selected from the group consisting of —N(R)—, —O—, —N(R)—R'—N(R)—, and —R—. (R and R' denote organic radicals of 1 to 10 carbon atoms) and X and Y are radicals selected from the group consisting of hydrogen, alkyl radicals of 1—8 carbon atoms, unsubstituted aromatic, alkyl, halogen, hydroxy and amino substituted aromatics, heterocyclic aromatics, 1—6 carbon alkyl substituted heterocyclic aromatic, amino, hydroxy, alkoxy and halogen radicals.

2. The use of a conductivity inducing glassy polymeric spun-on film forming composition for the boron/nitrogen doping of semiconductors, said composition containing at least 1.0% by weight in an organic solvent of a resin derived from the homopolymerization of monomers of formula $B(NHR)_3$ wherein R is selected from the group consisting of alkyl radicals of 1—4 carbon atoms, cyclohexyl, phenyl, and methyl- and ethyl-substituted phenyl radicals said resin being relatively less volatile than the solvent and being further polymerizable, upon deposition on a substrate and volatilization of the solvent, to yield an insoluble glassy film.

3. The composition of claim 1 wherein R is a cyclohexyl substituent.

4. The composition of claim 1 wherein R is a phenyl substituent.

5. The composition of claim 1 wherein R is a ethyl substituent.

6. The composition of any of claims 1 through 5 wherein the solvent is selected from xylene or toluene.

7. A method for forming a boron-nitrogen doped semi-conductor by applying a boron-nitrogen compound to the semi-conductor and thermally diffusing characterised in that a polymer film is applied to the surface of the semi-conductor by spin-on coating and the coated semi-conductor is subjected to heat treatment said polymer comprising a solution of at least 1.0% by weight in a volatile solvent of a nonvolatile, homogeneous, cross-linkable polymer at least a substantial part of the back-bone of which is selected from

(a) polymers with borazine rings linked directly between a boron in one ring and a nitrogen atom in the adjacent ring

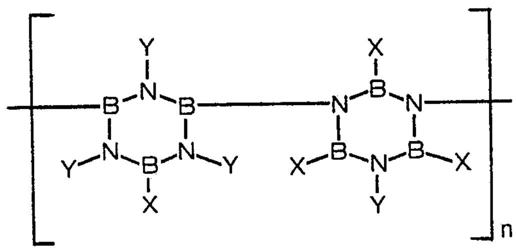

and

(b) polymers with borazine rings linked via groups Z.

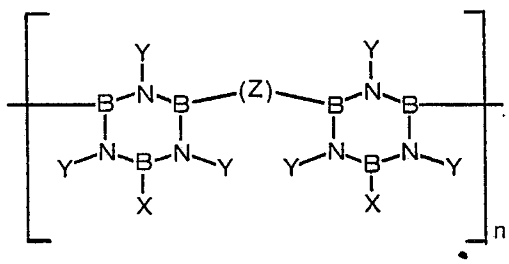

wherein X and Y locate the substituents on the ring boron and nitrogen atoms and Z is selected from the group consisting of —N(R)—, —O—, —N(R)—R′—N(R)—, or —R—. (R and R′ denote organic radicals of 1 to 10 carbon atoms) and X and Y are radicals selected from the group consisting of hydrogen, alkyl radicals of 1—8 carbon atoms, unsubstituted aromatic, alkyl, halogen, hydroxy and amino substituted aromatics, heterocyclic aromatics, 1—6 carbon alkyl substituted heterocyclic aromatic, amino, hydroxy, alkoxy and halogen radicals.

8. A method according to Claim 7 characterized by comprising dispensing the composition onto the surface of a silicon wafer, rotating the wafer at 2,000—10,000 rpm to produce a thin wafer of the order of 10—700 nm (100—7000Å) of the polymer on the substrate, heating the treated wafer in a diffusion furnace for up to 1 hour at 850°C—1100°C in a nitrogen ambient, deglazing the heated substrate in HF and heating the substrate at elevated temperature of 1050—1200°C for 1—2 hours under an atmosphere selected from oxygen, wet oxygen and nitrogen ambients and combinations thereof.

9. A method of doping semiconductor material comprising:

(a) spinning a semiconductor substrate

(b) simultaneously depositing on said substrate a solution of at least 1.0% by weight of a resin derived from the polymerization of a monomer of the formula

$$B(NHR)_3$$

wherein R is selected from the group consisting of alkyl radicals of 1—4 C atoms, cyclohexyl, phenyl, and methyl- and ethyl-substituted phenyl, radicals.

(c) heating said deposition until the solvent present in said solution is substantially volatilized;

(d) polymerizing said resin deposition of a glassy insoluble state and

(e) subjecting to a diffusing step.

10. The method of claim 8 wherein R is cyclohexyl.

11. A method of doping in accordance with claim 9, and thereafter diffusing into a semiconductor substrate wherein the diffusion of the applied dopant film effected in a one-tube diffusion comprising:

a) Placing the coated wafers in diffusion furnace for about 1 hour under nitrogen at a temperature between 850 and 1200°C;

b) Replacing the nitrogen ambient with wet oxygen after decreasing the temperature to between 700°C and 800°C for 15—30 minutes; and

c) Increasing the temperature to between 900 and 1250°C under a nitrogen, oxygen, and/or steam ambient, or any combination thereof, for the time needed to achieve the required junction depth.

**Patentansprüche**

1. Verwendung einer leitfähigmachenden, glasartigen, durch Schleudern eine Schicht bildenden polymeren Zusammensetzung zum Dotieren von Halbleitern mit Bor und Stickstoff, wobei die genannte Zusammensetzung in einem flüchtigen Lösungsmittel mindestens 1,0 Gew.% eines Polymers enthält, dessen Hauptkette mindestens zu einem beträchtlichen Teil ausgewählt ist aus

(a) den Polymeren mit Borazinringen, die direkt mit einem Boratom in einem Ring und einem Stickstoffatom in dem benachbarten Ring verbunden sind,

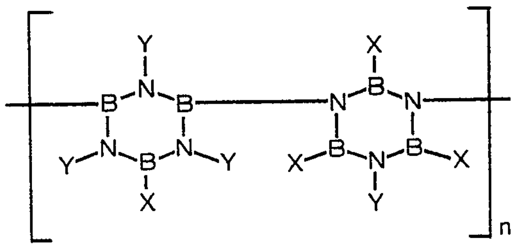

und

(b) den Polymeren mit Borazinringen, die durch Gruppen Z miteinander verbunden sind,

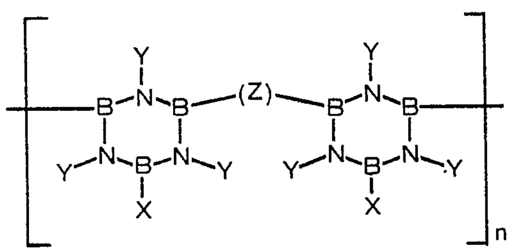

wobei X und Y die Anordnung der Substituenten an den Ringbor- und Ringkohlenstoffatomen angeben, Z aus der Gruppe ausgewählt ist, die aus —N(R)—, —O—, —N(R)—R'—N(R)— und —R— besteht, R und R' organische Radikale mit 1 bis 10 Kohlenstoffatomen sind und X und Y Radikale sind, die aus der Gruppe ausgewählt sind, die aus dem Wasserstoff, den Alkylradikalen mit 1 bis 8 Kohlenstoffatomen, den nichtsubstituierten Aromaten und den mit Alkyl, Halogen, Hydroxyl und Amino substituierten Aromaten, den heterozylklischen Aromaten, dem $C_1$—$C_6$-alkylsubstituierten heterozylklischen aromatischen Amino-, Hydroxy-, Alkoxy- und Halogenradikalen besteht.

2. Verwendung einer leitfähigmachenden glasartigen, durch Schleudern eine Schicht bildenden polymeren Zusammensetzung zum Dotieren von Halbleitern mit Bor und Stickstoff, wobei die Zusammensetzung in einem organischen Lösungsmittel mindestens 1,0 Gew.% eines Harzes enthält, das durch die Homopolymerisation von Monomeren der Formel $B(NHR)_3$ abgeleitet worden ist, in der R aus der Gruppe ausgewählt ist, die aus den Alkylradikalen mit 1 bis 4 Kohlenstoffatomen, de Cyclohexyl- und Phenylradikalen und den methyl- und ethylsubstituierten Phenylradikalen ausgewählt ist, wobei das genannte Harz relativ weniger flüchtig ist als das Lösungsmittel und nach seinem Auftragen auf das Substrat und den Verflüchtigungen des Lösungsmittels unter Bildung einer unlöslichen glasartigen Schicht weiterpolymerisierbar ist.

3. Zusammensetzung nach Anspruch 1, dadurch gekennzeichnet, daß R ein Cyclohexylsubstituent ist.

4. Zusammensetzung nach Anspruch 1, dadurch gekennzeichnet, daß R ein Phenylsubstituent ist.

5. Zusammensetzung nach Anspruch 1, dadurch gekennzeichnet, daß R ein Ethylsubstituent ist.

6. Zusammensetzung nach einem der Ansprüche 1 bis 5, dadurch gekennzeichnet, daß das Lösungsmittel aus dem Xylol und dem Toluol ausgewählt ist.

7. Verfahren zum Herstellen eines mit Bor und Stickstoff dotierten Halbleiter durch Auftragen einer Borstickstoffverbindung auf den Halbleiter und thermisches Diffundieren, dadurch gekennzeichnet, daß auf der Oberfläche des Halbleiters durch Schleudern ein Polymerfilm gebildet und der überzogene Halbleiter wärmebehandelt wird, wobei das Polymer mindestens teilweise aus einer mindestens 0,1-gewichtsprozentigen Lösung eines flüchtigen, homogenen vernetzbaren Polymers in einem flüchtigen Lösungsmittel besteht und mindestens ein beträchtlicher Teil der Hauptkette dieses nichtflüchtigen Polymers ausgewählt ist aus:

(a) den Polymeren mit Borazinringen, die direkt mit einem Boratom in einem Ring und einem Stickstoffatom in dem benachbarten Ring verbunden sind,

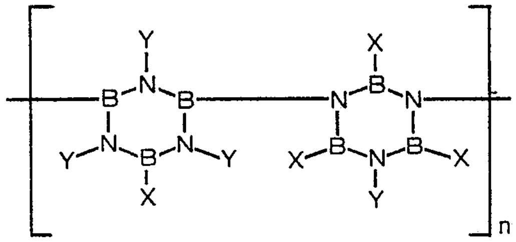

und

(b) den Polymeren mit Borazinringen, die durch Gruppen Z miteinander verbunden sind,

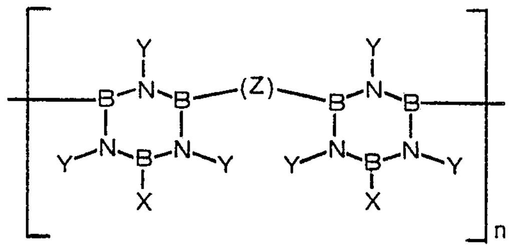

wobei X und Y die Anordnung der Substituenten an den Ringbor- und Ringkohlenstoffatomen angeben, Z aus der Gruppe ausgewählt ist, die aus —N(R)—, —O—, —N(R)—R'—N(R)— und —R— besteht, R und R' organische Radikale mit 1 bis 10 Kohlenstoffatomen sind und X und Y Radikale sind, die aus der Gruppe ausgewählt sind, die aus dem Wasserstoff, den Alkylradikalen mit 1 bis 8 Kohlenstoffatomen, den nichtsubstituierten Aromaten und den mit Alkyl, Halogen, Hydroxyl und Amino substituierten Aromaten, den heterozylkischen Aromaten, dem $C_1$—$C_6$-alkylsubstituierten heterozylkoschen aromatischen Amino-, Hydroxy-, Alkoxy- und Halogenradikalen besteht.

8. Verfahren nach Anspruch 7, dadurch gekennzeichnet, daß die Zusammensetzung auf die Oberfläche einer Siliciumscheibe gebracht wird, daß zur Bildung einer dünnen Schicht des Polymers in einer Größenordnung von 10 bis 700 nm auf dem Substrat die Scheibe mit 200 bis 10000 gedreht wird, daß die behandelte Scheibe in einem Diffusionsofen in einer Stickstoffatmosphäre bis zu einer Stunde lang auf einer Temperatur von 850 bis 1100° gehalten wird, daß das erhitzte Substrat in HF glanzlos gemacht und daß das Substrat in einer Atmosphäre, die aus Sauerstoff, nassem Sauerstoff und Stickstoff sowie Kombinationen derselben besteht, bis zu 2 Stunden lang auf einer erhöhten Temperatur von 1050 bis 1200°C gehalten wird.

9. Verfahren zum Dotieren von Halbleitermaterial, in dem

(a) eine Halbleitersubstrat schnellgedreht wird,

(b) dabei auf das Substrat eine mindestens 1,0-gewichtsprozentige Lösung eines Harzes aufgetragen wird, das durch die Polymerisation eines Monomers der Formel

$$B(NHR)_3$$

in der R aus der Gruppe ausgewählt ist, die aus den Alkylradikalen mit 1 bis 4 Kohlenstoffatomen, den Cyclohexyl- und Phenylradikalen und den methyl- und ethylsubstituierten Phenylradikalen ausgewählt ist

(c) der Auftrag erhitzt wird, bis das in der Lösung enthaltene Lösungsmittel im wesentlichen verflüchtigt ist,

(d) der Harzauftrag in enen glasartigen, unlöslichen Zustand polymerisiert wird und

(e) ein Diffusionsschritt durchgeführt wird.

10. Verfahren nach Anspruch 8, dadurch gekennzeichnet, daß R Cyclohexyl ist.

11. Verfahren zum Dotieren nach Anspruch 9 mit darauffolgenden Diffundieren in ein Halbleitersubstrat, wobei die Diffusion des aufgetragenen Dotierstoffes durch Einrohr-diffusion durchgeführt wird, in dem

(a) die beschichteten Scheiben in einem Diffusionsofen unter Stickoff etwa 1 Stunde auf einer Temperatur zwischen 850 und 1200°C gehalten werden;

(b) 15 bis 30 min eine niedrigere Temperatur zwischen 700 und 800°C aufrechterhalten und danach die Stickstoffatmosphäre durch nassen Sauerstoff ersetzt wird und

(c) unter einer Atmosphäre aus Stickstoff, Sauerstoff und/oder Wasserdampf oder einer beliebigen Kombination derselben solange eine höhere Temperatur zwischen 900 und 1250°C aufrechterhalten wird, wie es zum Erzielen einer Sperrschicht in der erforderlichen Tiefe erforderlich ist.

**Revendications**

1. Utilisation d'une composition filmogène ou feuillogène déposée par rotation, polymère, vitreuse ou hyaline induisant une conductivité, pour le dopage borazoté de semi-conducteurs, ladite composition contenant au moins 1,0% en poids dans un solvant volatil d'un polymère dont au moins une partie substantielle de l'ossature est choisie parmi:

(a) les polymères avec des noyaux borazine directement liés entre un atome de bore dans un noyau et un atome d'azote dans le noyau voisin

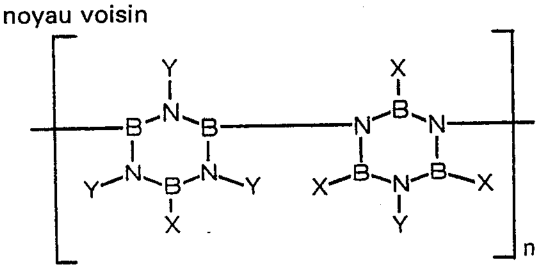

et

(b) les polymères avec des noyaux borazine liés par l'intermédiaire de radicaux Z:

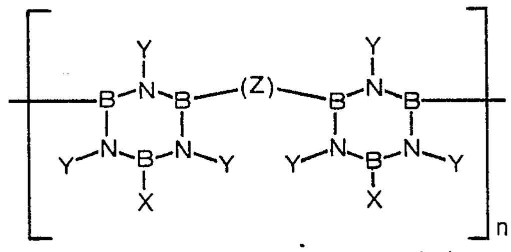

où X et Y localisent les substituants sur les atomes d'azote et de bore cycliques et Z est choisi dans le groupe formé par les radicaux —N(R)—, —O—, —N(R)—R'—N(R)—, ou —R— (R et R' désignent des radicaux organiques possédant de 1 à 10 atoms de carbone) et X et Y sont des radicaux choisis dans le groupe constitué de l'hydrogène, des radicaux alkyle possédant de 1 à 8 atomes de carbone, des radicaux aromatiques non substitués, des radicaux aromatiques à substitution alkylique, halogénée, hydroxylée et aminée, des radicaux aromatiques hétérocycliques, des radicaux aromatiques hétérocycliques à substitution alkylique à 1—6 atomes de carbone, des radicaux amino, hydroxyle, alcoxy et halogène.

2. Utilisation d'une composition filmogène ou feuillogène déposée par rotation, polymère, vitreuse ou hyaline induisant une conductivité, pour le dopage borazoté de semi-conducteurs, ladite composition contenant au moins 1,0% en poids dans un solvant organique d'un polymère dérivé de l'homopolymérisation de monomères de la formule $B(NHR)_3$ dans laquelle R est choisi dans le groupe constitué des radicaux alkyle possédant de 1 à 4 atomes de carbone, des radicaux cyclohexyle, phényle et phényle à substitution méthylique et éthylique, ladite résine étant relativement moins volatile que le solvant et étant davantage polymérisable, par déposition sur un substrat et volatilisation du solvant, de façon à obtenir une pellicule vitreuse ou hyaline insoluble.

3. Composition suivant la revendication 1, caractérisée en ce que R est un substituant du type cyclohexyle.

4. Composition suivant la revendication 1, caractérisée en ce que R est un substituant du type phényle.

5. Composition suivant la revendication 1, caractérisée en ce que R est un substituant du type éthyle.

6. Composition suivant l'une quelconque des revendications 1 à 5, caractérisée en ce que le solvant est choisi parmi le xylène et le toluène.

7. Procédé pour former un semi-conducteur à dopage borazoté par l'application d'un composé borazoté au semi-conducteur et diffusion thermique, caractérisée en ce que l'on applique la pellicule de polymère sur la surface du semi-conducteur par un revêtement de déposition de rotation et on soumet le semi-conducteur ainsi revêteu à un traitement thermique, le polymère en question comprenant une solution d'au moins 1,0% en poids dans un solvant volatil d'un polymère non volatil, homogène, réticulable, dont au moins une partie substantielle de l'ossature est choisie parmi

(a)les polymères avec des noyaux borazine directement liés entre un atome de bore dans un noyau et un atome d'azote dans le noyau voisin

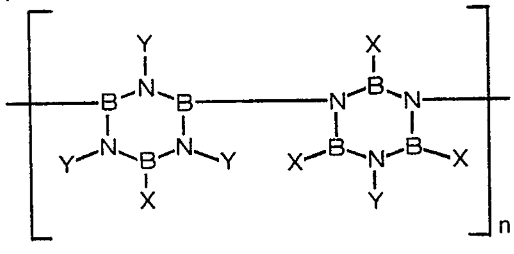

et

(b) les polymères avec des noyaux borazine liés par l'intermédiaire de radicaux Z:

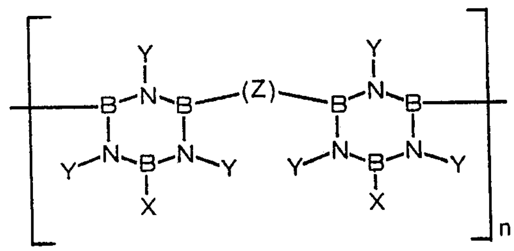

où X et Y localisent les substituants sur les atomes d'azote et de bore cycliques et Z est choisi dans le groupe formé par les radicaux —N(R)—, —O—, —N(R)—R'—N(R)— et —R— (R et R' désignent des radicaux organiques possédant de 1 à 10 atoms de carbone) et X et Y sont des radicaux choisis dans le groupe formé par l'hydrogène, les radicaux alkyle possédant de 1 à 8 atoms de carbone, les radicaux aromatiques non substitués, les radicaux aromatiques à substitution alkylique, halogénée, hydroxylée et aminée, les radicaux aromatiques hétérocycliques, les radicaux aromatiques hétérocycliques à substitution alkylique à 1—6 atomes de carbone, les radicaux amino, hydroxyle, alcoxy et halogène.

8. Procédé suivant la revendication 7, caractérisé en ce qu'il comprend la distribution de la composition à la surface d'une galette de silicium, la rotation de la galette à 2000—10000 tpm pour engendrer une mince pellicule de l'ordre de 10—700 nm du polymère sur le substrat, le chauffage de la galette traitée dans un four de fiffusion pendant une heure à 850—1100°C sous atmosphère d'azote, le déglaçage du substrat chauffé dans de l'HF et le chauffage du substrat à une température élevée de 1050—1200°C pendant 1 à 2 heures sous une atmosphère choisie parmi l'oxygène, l'oxygène humide et l'azote et leurs combinaisons.

9. Procédé de dopage d'une matière semi-conductrice, caractérisé en ce que:

(a) on fait tourner un substrat semi-conducteur,

(b) on dépose simultanément sur ce substrat une solution d'au moins 1,0% en poids d'une résine provenant de la polymérisation d'un monomère de la formule

$$B(NHR)_3$$

dans laquelle R est choisi dans le groupe formé par les radicaux alkyle possédant de 1 à 4 atomes de carbone, cyclohexyle, phényle, phényle à substitution méthylique et éthylique,

(c) on chauffe le dépôt ainsi obtenu jusqu'à ce que le solvant présent dans ladite solution soit sensiblement volatilisé;

(d) on polymérise le dépôt de résine jusqu'à un état vitreux ou hyalin insoluble; et

(e) on le soumet à une étape de diffusion.

10. Procédé suivant la revendication 8, caractérisé en ce que R représente le radical cyclohexyle.

11. Procédé de dopage suivant la revendication 9 et de diffusion subséquent dans un substrat semi-conducteur où la diffusion de la pellicule de produit de dopage appliquée s'effectue dans un seul tube de diffusion, caractérisé en ce que:

a) on place les galettes revêtues dans un four de diffusion à une température variant de 850 à 1200°C, pendant environ une heure, sous atmosphère d'azote;

b) on remplace l'atmosphère d'azote par une atmosphère d'oxygène humide après avoir réduit la température à une valeur variant de 700°C à 800°C, pendant 15 à 30 minutes; et

c) on élève la température à une valeur variant de 900 à 1250°C, sous une atmosphère d'azote, d'oxygène et/ou de vapeur d'eau ou n'importe quelle combinaison de ces atmosphères, pendant la période nécessaire à parvenir à la profondeur de jonction voulue.